(19) Europäisches Patentamt
European Patent Office
Office européen des brevets

(11) **EP 4 607 288 B1**

(12) **EUROPEAN PATENT SPECIFICATION**

(45) Date of publication and mention
of the grant of the patent:
**24.06.2026 Bulletin 2026/26**

(21) Application number: **25158724.2**

(22) Date of filing: **19.02.2025**

(51) International Patent Classification (IPC):
*G04B 15/14* (2006.01)   *G04B 45/00* (2006.01)
*G04B 45/02* (2006.01)   *A44C 27/00* (2006.01)
*C23C 14/06* (2006.01)   *C23C 14/08* (2006.01)
*C23C 14/16* (2006.01)

(52) Cooperative Patent Classification (CPC):
**G04B 45/0007; C23C 16/34; C23C 16/40;
C23C 16/45525; G04B 15/14; G04B 45/02**

(54) **WATCH PART AND WATCH**

UHRENTEIL UND UHR

PIÈCE DE MONTRE ET MONTRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **21.02.2024   JP 2024024390**

(43) Date of publication of application:
**27.08.2025 Bulletin 2025/35**

(73) Proprietor: **Seiko Epson Corporation
Tokyo 160-8801 (JP)**

(72) Inventors:
• **TERADAIRA, Naruki
Suwa-shi, 392-8502 (JP)**
• **FUNAKAWA, Takeo
Suwa-shi, 392-8502 (JP)**

(74) Representative: **Lewis Silkin LLP
Arbor
255 Blackfriars Road
London SE1 9AX (GB)**

(56) References cited:
**EP-A1- 3 896 193        EP-B1- 2 149 540
JP-A- 2020 148 651      US-A1- 2018 217 559
US-A1- 2020 292 991**

**Description**

The present application is based on, and claims priority from JP Application Serial Number 2024-024390, filed February 21, 2024, the disclosure of which is hereby incorporated by reference herein in its entirety.

BACKGROUND

1. Technical Field

The present disclosure relates to a watch part and a watch.

2. Related Art

JP-A-2020-148651 discloses that a light-reflecting layer having a three-layer structure in which a first silicon oxide layer, a silicon layer, and a second silicon oxide layer are stacked in this order is disposed on a base material containing silicon as a primary component.

According to JP-A-2020-148651, since three layers composed of the silicon oxide layer serving as a relatively-low refractive index layer and the silicon layer serving as a relatively-high refractive index layer which are alternately stacked on the silicon base material, decoration can be performed with favorable color developability compared with the instance in which a single silicon oxide layer is stacked on the base material.

In JP-A-2020-148651, the third layer is formed using silicon oxide. In such an instance, there is a problem that it is difficult to realize quiet, deep color development since the brightness is increased by merely changing the layer thickness of the third layer.

US 2020/292991 A1 discloses a watch part according to the preamble of claim 1.

SUMMARY

According to an aspect of the present disclosure, a watch part includes a base material having a watch part shape and containing silicon as a primary component and a light-reflecting layer stacked on the base material, wherein the light-reflecting layer includes a first layer, a second layer, and a third layer which are successively stacked in this order from the base material, the first layer is formed using silicon oxide, the second layer is formed using silicon, and the third layer is formed using a material having a refractive index of 1.7 to 2.7.

According to an aspect of the present disclosure, a watch includes the above-described watch part.

BRIEF DESCRIPTION OF THE DRAWINGS

FIG. 1 is an elevation view illustrating a watch according to an embodiment when viewed from a dial side.
FIG. 2 is a diagram illustrating the watch according to the embodiment when viewed from a case back side.
FIG. 3 is a plan view illustrating an escape wheel and pinion portion according to the embodiment.
FIG. 4 is a partial sectional view of the escape wheel and pinion portion according to the embodiment.
FIG. 5 is a model diagram illustrating the light reflection by a light-reflecting layer.
FIG. 6 is a flow sheet illustrating a producing method of the escape wheel and pinion according to the embodiment.

DESCRIPTION OF EMBODIMENTS

Embodiments

A watch 1 according to an embodiment of the present disclosure will be described below with reference to the drawings.

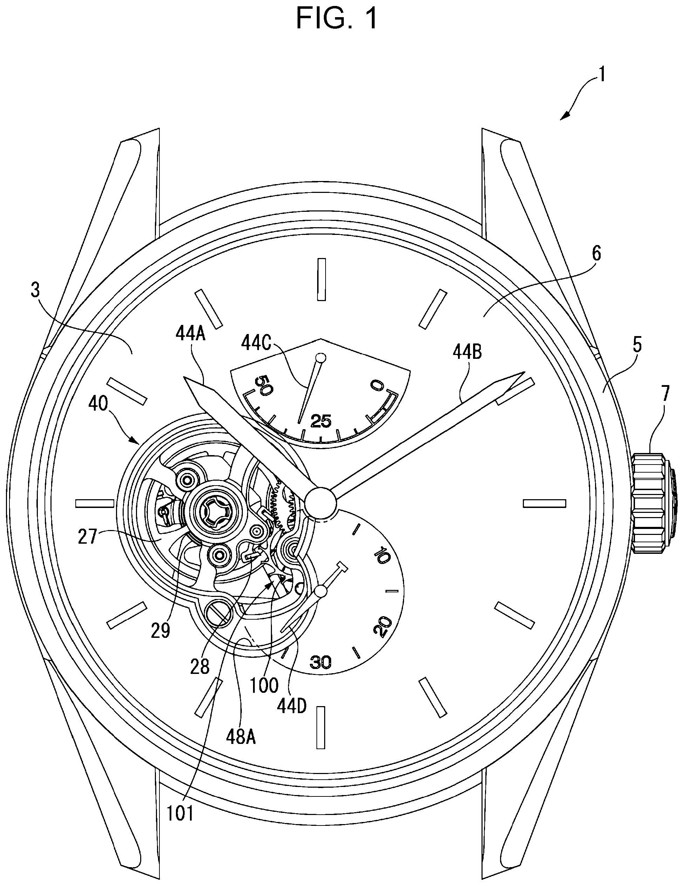

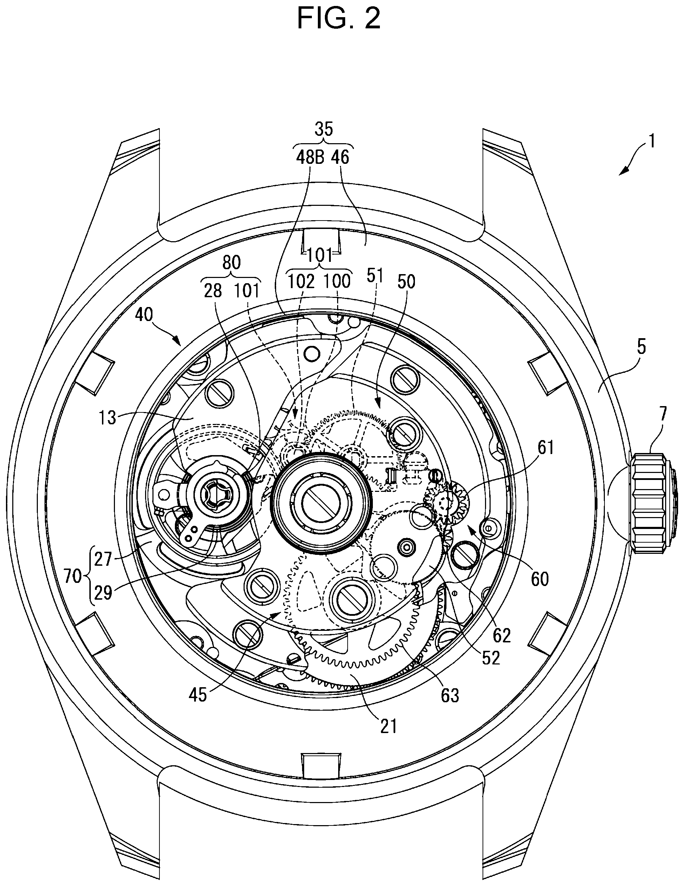

FIG. 1 is an elevation view illustrating the watch 1, and FIG. 2 is a diagram illustrating the watch 1 when viewed from a case back side. In the present embodiment, the watch 1 is configured to be a mechanical wristwatch that is put on a wrist of a user. In this regard, the watch 1 has a see-through structure in which a portion of a movement 40 can be perceived from the dial 3 side and the case back 35 side.

As illustrated in FIG. 1 and FIG. 2, the watch 1 includes a cylindrical outer case 5, and a disc-like dial 3 is disposed on the inner circumferential side of the outer case 5. The dial 3 is provided with a window 48A. The watch 1 has a configuration in which a portion of the movement 40 is perceived through the window 48A.

Of two openings of the outer case 5, a surface-side opening is closed by a cover glass 6 having translucency, and a back-surface-side opening is provided with the case back 35.

In this regard, the watch 1 includes the movement 40 housed in the outer case 5, an hour hand 44A and a minute hand 44B which indicate time information, a power reserve hand 44C which indicates the duration due to a mainspring, and a small seconds hand 44D.

The hour hand 44A, the minute hand 44B, the power reserve hand 44C, and the small seconds hand 44D are attached to an indicator hand shaft of the movement 40 and driven by the movement 40.

A crown 7 is disposed on the side surface of the outer case 5. When the crown 7 is operated, an input corresponding to the operation can be performed.

Further, in FIG. 1, an escape wheel and pinion 101, a pallet fork 28, a balance wheel 27, a hairspring 29, and the like which constitute a portion of the movement 40 can be perceived through the window 48A disposed in the dial 3 when viewed from the dial 3 side.

In addition, the escape wheel and pinion 101 includes the escape wheel and pinion portion 100 and a shaft member 102. In this regard, the escape wheel and pinion portion 100 is an example of the watch part according to the present disclosure.

The case back 35 is composed of a ring-like frame member 46 which forms an outer circumferential portion and the window 48B formed from a transparent member fit into the frame member 46.

The movement 40 includes a train wheel 45, a balance bridge 13, a manual winding mechanism 60, an automatic winding mechanism 50, and the like.

The train wheel 45 includes a movement barrel complete 21, a center wheel and pinion, a third wheel and pinion, a fourth wheel and pinion 51, the escape wheel and pinion 101, the pallet fork 28, the balance wheel 27, and the like which are disposed on the case back side of a main plate. FIG. 2 illustrates the movement barrel complete 21, the fourth wheel and pinion 51, the escape wheel and pinion 101, the pallet fork 28, and the balance wheel 27. The escape wheel and pinion 101 and the pallet fork 28 constitute an escapement 80, and the balance wheel 27 and the hairspring 29 constitute a speed governor 70.

The manual winding mechanism 60 includes a setting stem, a winding pinion, a clutch wheel, a crown wheel 61, an intermediate ratchet wheel 62, a ratchet wheel 63, and the like. FIG. 2 illustrates the crown wheel 61, the intermediate ratchet wheel 62, and the ratchet wheel 63.

The automatic winding mechanism 50 includes an oscillating weight, a bearing, an eccentric wheel, a pawl lever, a transmission wheel 52, and the like. FIG. 2 illustrates the transmission wheel 52.

In FIG. 2, the movement barrel complete 21, the escape wheel and pinion 101, the pallet fork 28, the balance wheel 27, the crown wheel 61, the intermediate ratchet wheel 62, the ratchet wheel 63, the eccentric wheel, the transmission wheel 52, and the like which constitute a portion of the movement 40 can be perceived from the case back 35 side through the window 48B disposed in the case back 35.

As described above, in the present embodiment, since the escape wheel and pinion portion 100 of the escape wheel and pinion 101 can be perceived through the window 48A of the dial 3 and the cover glass 6, the design flexibility of the watch 1 can be enhanced. Further, since the escape wheel and pinion portion 100 of the escape wheel and pinion 101 can be perceived from the case back 35 side through the window 48B disposed in the case back 35, the design flexibility of the watch 1 can be enhanced.

In this regard, in the watch 1, an aspect in which the constituent part of the movement 40 is perceived from the dial 3 side or the case back 35 side is not limited to the above-described aspect.

For example, a predetermined constituent part of the movement 40 may be made perceivable by appropriately changing the design, the size, the arrangement position, the number of windows, and the like of the windows 48A and 48B.

In addition, the entire dial 3 may be formed of a transparent material, and the entire movement 40 may be made perceivable from the dial side. Alternatively, the entire case back 35 may be formed of a transparent material, and the entire movement 40 may be made perceivable from the case back side.

Escape wheel and pinion portion

Next, the configuration of the escape wheel and pinion portion 100 will be described in detail.

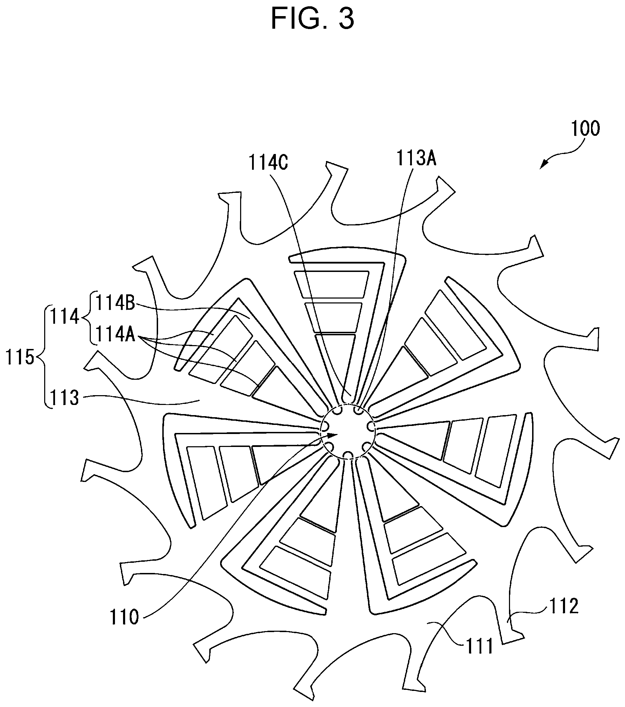

FIG. 3 is a plan view illustrating the escape wheel and pinion portion 100.

As illustrated in FIG. 3, the escape wheel and pinion portion 100 has an insertion portion 110 into which a shaft member 102 is inserted in the central portion.

The escape wheel and pinion portion 100 has a rim portion 111 including a plurality of tooth portions 112 and a hold portion 115 to hold the shaft member 102. The rim portion 111 is a ring-like portion of an outer edge of the escape wheel and pinion portion 100. The tooth portion 112 is disposed protruding outward from the outer circumference of the rim portion 111 and is formed into a specific hook shape.

The escape wheel and pinion portion 100 has seven hold portions 115. The hold portions 115 are arranged at seven places in the circumferential direction of the ring-like rim portion 111 with an equal pitch of 360°/7. In this regard, there is no particular limitation regarding the number of the hold portions 115, and the number may be within the range of 3 to 7 or may be 7 or more.

The hold portion 115 has a first hold portion 113 extending from the rim portion 111 and a second hold portion 114 disposed by being branched from the first hold portion 113. The first hold portion 113, the second hold portion 114, and the rim portion 111 are integrally formed of the same material.

The first hold portion 113 is formed extending from the rim portion 111 in the direction toward the shaft member 102 so that the width dimension decreases with increasing proximity to the shaft member 102. An end on the shaft member 102 side of the first hold portion 113 is set to be a contact portion 113A in contact with the shaft member 102. The contact portion 113A is formed having the shape of an arc in plan view.

The second hold portion 114 has a first portion 114A and a second portion 114B. The second hold portion 114 has functions of fixing the shaft member 102 to the center of the escape wheel and pinion portion 100 and suppressing the escape wheel and pinion portion 100 from inclining with respect to or coming out of the shaft member 102.

The first portion 114A is formed by being connected to the first hold portion 113 and by being branched from the first hold portion 113 and extends in the direction intersecting the extension direction of the first hold portion 113. The second hold portion 114 has a plurality of first portions 114A. The plurality of first portions 114A are arranged substantially parallel to each other. The second portion 114B is connected to the plurality of first portions 114A and extends in the direction toward the shaft member 102. The width direction of the second portion 114B is substantially constant, and an end on the shaft member 102 side is set to be a contact portion 114C in contact with the shaft member 102. The contact portion 114C is formed having the shape of an arc in plan view.

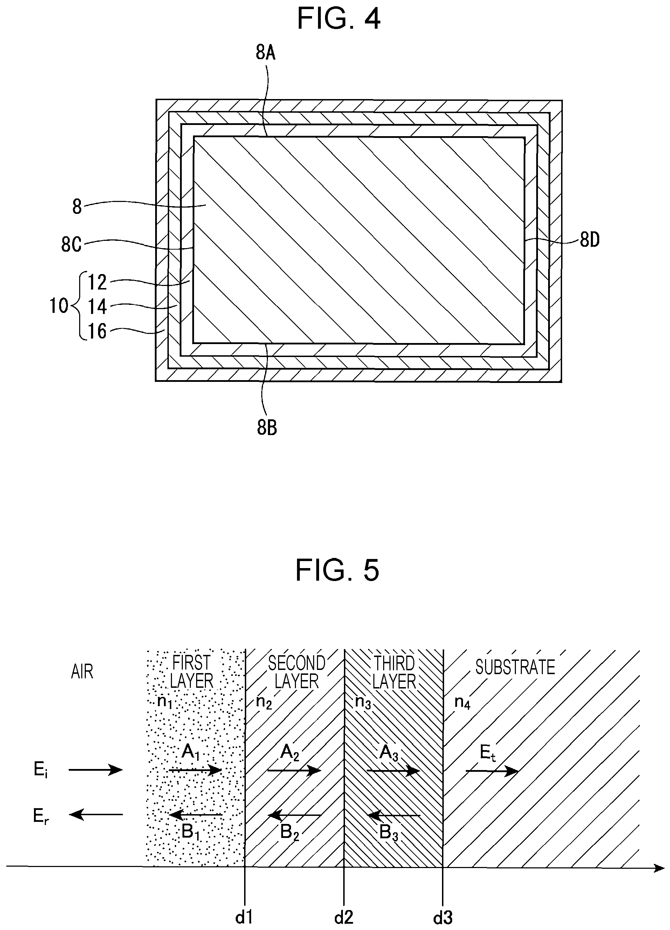

Next, the cross-sectional structure of the escape wheel and pinion portion 100 will be described. FIG. 4 is a partial sectional view of the escape wheel and pinion portion 100.

As illustrated in FIG. 4, the escape wheel and pinion portion 100 includes a base material 8 containing silicon as a primary component. The base material 8 has a first surface 8A, a second surface 8B opposite to the first surface 8A, and a third surface 8C and a fourth surface 8D, each connecting the first surface 8A to the second surface 8B.

In this regard, in the present specification, the first surface 8A of the base material 8 means a surface on the watch-part perception side when a watch is equipped with the watch part.

When the watch is equipped with the watch part and the watch part can be perceived from the case back side of the watch, the first surface 8A of the base material 8 means a surface located on the case back side of the watch. In this regard, when the watch part is perceived from the dial side and the case back side of the watch, the first surface 8A of the base material 8 is assumed to be a surface located on the dial side of the watch.

Herein, in the present embodiment, since the escape wheel and pinion portion 100 serving as the watch part is perceived from the dial 3 side and the case back 35 side of the watch 1, the first surface 8A of the base material 8 is a surface located on the dial 3 side, and the second surface 8B of the base material 8 is a surface located on the case back 35 side.

In the present specification, the base material 8 means a watch part in the state in which a light-reflecting layer 10 is not formed. In the present embodiment, the base material 8 means the escape wheel and pinion portion 100 in the state in which the light-reflecting layer 10 is not formed. That is, the base material 8 has the shape as a watch part, and in the present embodiment, the base material 8 has the shape of the escape wheel and pinion portion 100.

In addition, in the present specification, "containing silicon as a primary component" means that the content of silicon on a mass basis relative to the total base material is 80% by mass or more. The silicon content is preferably 90% by mass or more and more preferably 95% by mass or more.

In the following explanations, the base material 8 containing silicon as a primary component is also referred to as the silicon base material 8 or simply as the base material 8.

To begin with, the configuration on the first surface 8A side of the base material 8 will be described.

As illustrated in FIG. 4, the escape wheel and pinion portion 100 includes the light-reflecting layer 10 having a three-layer structure in which a first layer 12, a second layer 14, and a third layer 16 are stacked in this order on the first surface 8A, the second surface 8B, and the third surface 8C of the base material 8.

Base material

The base material 8 contains silicon as a primary component. There is no particular limitation regarding the type of silicon, and appropriate silicon can be selected from the viewpoint of workability. Examples of silicon include single crystal silicon and polycrystal silicon. One type of these may be used alone, or two or more types thereof may be used in combination.

Since the silicon base material 8 can be produced by, for example, a photolithography technology or an etching technology, a complex shape can be formed.

Light-reflecting layer

The light-reflecting layer 10 includes the first layer 12, the second layer 14, and the third layer 16 in this order on the base material 8. In the present embodiment, the light-reflecting layer 10 is disposed on the first surface 8A, the second surface 8B, the third surface 8C, and the fourth surface 8D of the base material 8, that is, on the entire surface of the base material 8, and has a three-layer structure. The light-reflecting layer may have, for example, a five-layer structure, but a three-layer structure is favorable from the viewpoint of readily adjusting the color.

First layer

The first layer 12 is disposed on the base material 8. In the present embodiment, the first layer 12 is disposed on the first surface 8A, the second surface 8B, the third surface 8C, and the fourth surface 8D of the base material 8. In this regard, in the present embodiment, the first layer 12 is formed using silicon oxide.

The layer thickness of the first layer 12 is appropriately adjusted in accordance with the color of color development and may be usually 50 nm or more and 600 nm or less. Consequently, since the first layer 12 is 50 nm or more, the layer thickness of the first layer 12 can be readily controlled. In addition, since the first layer 12 is 600 nm or less, formation of the first layer 12 can be suppressed from taking excessive time.

In this regard, the first layer 12 may be a silicon oxide layer formed by a thermal oxidation method. The silicon oxide layer being formed by the thermal oxidation method tends to obtain a silicon oxide layer having high homogeneity.

Second layer

The second layer 14 is disposed on the first layer 12. In the present embodiment, the second layer 14 is disposed on the entire surface of the first layer 12. In addition, in the present embodiment, the second layer 14 is formed using silicon.

In this regard, the second layer 14 may be an amorphous layer or a polysilicon layer, but a polysilicon layer is favorable.

The layer thickness of the second layer 14 is appropriately adjusted in accordance with the color of color development and may be usually 20 nm or more and 300 nm or less. Consequently, since the second layer 14 is 20 nm or more, the layer thickness of the second layer 14 can be readily controlled. In addition, since the layer thickness of the second layer 14 is 300 nm or less, excessive approach to the hue of the second layer 14 having a high refractive index can be suppressed.

Third layer

The third layer 16 is disposed on the second layer 14. In the present embodiment, the third layer 16 is disposed on the entire surface of the second layer 14. In this regard, in the present embodiment, the third layer 16 is formed of a material having a refractive index different from that of the second layer 14 by using an atomic layer deposition method (ALD method). Specifically, the third layer 16 is formed using any one of aluminum oxide, aluminum nitride, silicon nitride, titanium oxide, and hafnium oxide by the ALD method.

Herein, the ALD method is a technology to form a metal oxide film or a metal nitride film on an object by alternately passing a gas containing a metal element called a precursor and a reaction species gas called a reactant, for example, water, ozone, oxygen, or ammonia. One of the features of the ALD method is that various types of film species can be made into a film since many materials serve as the precursor.

The layer thickness of the third layer 16 is appropriately adjusted in accordance with the color of color development and may be usually 10 nm or more and 150 nm or less. Consequently, since the third layer 16 is 10 nm or more, the reflectance due to the third layer 16 can be ensured and a predetermined hue can be readily realized. In addition, since the third layer 16 is 150 nm or less, formation of the third layer 16 can be suppressed from taking excessive time.

Further, the refractive index of the third layer 16 at a wavelength of 632.8 nm may be 1.7 or more and 2.7 or less. Consequently, a difference in the refractive index between the second layer 14 formed using silicon and the third layer 16 being decreased enables color development to be suppressed and enables a quiet, deep watch part to be realized.

In this regard, the refractive index is a value intrinsic to a substance. Regarding the refractive index of the material for forming the third layer 16 exemplified above, aluminum oxide is 1.7, aluminum nitride is 2.0, silicon nitride is 1.8, titanium oxide is 2.5 to 2.7, and hafnium oxide is 1.9. That is, the refractive index of the third layer 16 can be set to be 1.7 or more and 2.7 or less by adopting any one of aluminum oxide, aluminum nitride, silicon nitride, titanium oxide, and hafnium oxide as the material for forming the third layer 16.

Light reflectance due to light-reflecting layer

Next, the light reflectance due to a light-reflecting layer in which three layers of films are stacked will be described.

FIG. 5 is a model diagram illustrating the light reflection by a light-reflecting layer.

When light is incident on a light-reflecting layer in which three layers of films are stacked as illustrated in FIG. 5 at an incident angle of 0°, the reflectance R of the light is determined by Formula (1) to Formula (5) below described in "Fotonikku Kesshou Nyuumon (introduction to Photonic Crystal)" (Kazuaki Sakota, Morikita Publishing Co., Ltd., p. 28-32, 41-43, 2004).

$$M_j = \begin{pmatrix} \dfrac{n_j + n_{j+1}}{2n_j} e^{\frac{-i2\pi}{\lambda}(n_j - n_{j+1})d_j} & \dfrac{n_j - n_{j+1}}{2n_j} e^{\frac{-i2\pi}{\lambda}(n_j + n_{j+1})d_j} \\ \dfrac{n_j - n_{j+1}}{2n_j} e^{\frac{i2\pi}{\lambda}(n_j + n_{j+1})d_j} & \dfrac{n_j + n_{j+1}}{2n_j} e^{\frac{i2\pi}{\lambda}(n_j - n_{j+1})d_j} \end{pmatrix}$$

Formula (1)

$$\begin{pmatrix} A_j \\ B_j \end{pmatrix} = M_j \begin{pmatrix} A_{j+1} \\ B_{j+1} \end{pmatrix}$$

Formula (2)

$$M = M_0 M_1 M_2 M_3$$

Formula (3)

$$\begin{pmatrix} E_i \\ E_r \end{pmatrix} = M \begin{pmatrix} E_t \\ 0 \end{pmatrix} = \begin{pmatrix} M_{11} E_t \\ M_{21} E_t \end{pmatrix}$$

Formula (4)

$$R = \left| \frac{E_r}{E_i} \right|^2 = \left| \frac{M_{21}}{M_{11}} \right|^2$$

Formula (5)

In Formula (1) to Formula (5), $\lambda$ denotes a wavelength of the light, $n_j$ denotes a refractive index of the jth layer, $d_j$ denotes a layer thickness up to the jth layer, $E_i$ denotes an amplitude of the incident light, $E_r$ denotes an amplitude of the reflected light, and Et denotes an amplitude of the transmitted light. In addition, $A_j$ denotes an amplitude of the light that propagates through each layer in the same direction as $E_i$, and $B_j$ denotes an amplitude of the light that propagates through each layer in the same direction as $E_r$.

Herein, according to Formula (5) indicating the reflectance R, it is clear that the reflectance R can be calculated by the ratio of the 21 component to the 11 component of the matrix M. Further, each component of M is determined by the refractive index n and the layer thickness d in addition to the wavelength $\lambda$. In this regard, the refractive index n is a value intrinsic to a substance and, therefore, is determined in accordance with the material for forming the film, and the layer thickness d can be adjusted to a predetermined value by adopting a suitable producing method. That is, to intensely reflect specific light, in other words, to realize a predetermined hue, it is sufficient that production be performed so as to make the refractive index n and the layer thickness d to satisfy a specific condition.

Accordingly, in the present embodiment, since the ALD method is used for forming the third layer 16, the third layer 16 can be formed using materials having various refractive indices. Therefore, a realizable hue can be increased.

In this regard, when the third layer is stacked by the thermal oxidation method on the second layer 14 formed using silicon, variations in the layer thicknesses of the silicon layer serving as the second layer 14 and the third layer 16 occur from production to production due to the crystallinity, density, and the like of the silicon layer serving as the second layer 14. Consequently, there is a problem that it is difficult to perform adjustment to a predetermined hue. On the other hand, in the present embodiment, the layer thickness of the second layer 14 is not changed since the third layer 16 is formed by using the ALD method. Therefore, adjustment to a predetermined hue can be readily performed.

Further, since the first layer 12 formed using silicon oxide is stacked on the base material 8, the durability of the base material 8 can be enhanced.

Producing method of escape wheel and pinion

Next, the producing method of the escape wheel and pinion 101 will be described.

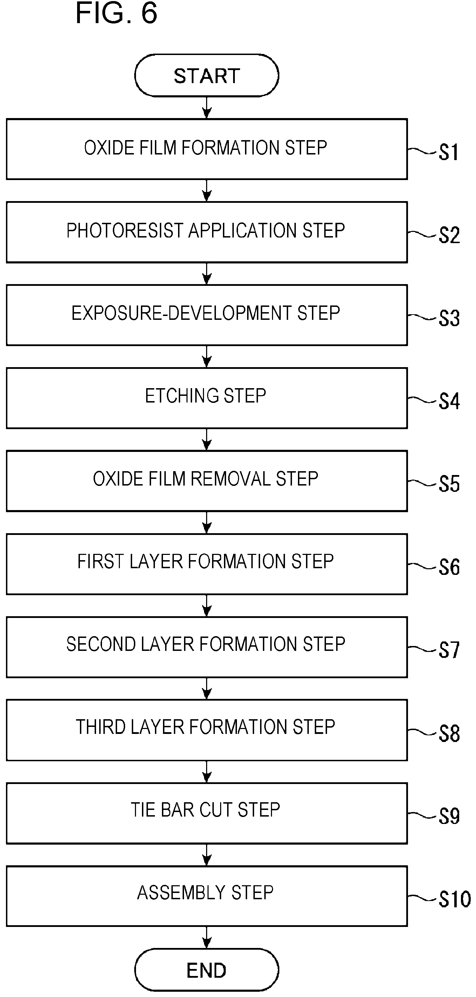

FIG. 6 is a flow sheet illustrating the producing method of the escape wheel and pinion 101.

As illustrated in FIG. 6, initially, in Step S1, an oxide film formation step is performed. Specifically, a silicon oxide film is formed on one flat surface of a tabular silicon wafer formed using silicon.

Subsequently, in Step S2, a photoresist application step is performed. Specifically, a photoresist is applied to the other flat surface of the silicon wafer, and drying is performed.

In Step S3, an exposure-development step is performed. Specifically, a mask having the shapes of the base material 8 of the escape wheel and pinion portion 100 and a tie bar is formed.

In Step S4, an etching step is performed. Specifically, the silicon wafer is etched so as to form the shapes of the base material 8 of the escape wheel and pinion portion 100 and the tie bar supporting the base material 8. Herein, the silicon oxide film formed in Step S1 suppresses a hole formed by etching from passing through.

In Step S5, an oxide film removal step is performed. Specifically, the silicon oxide film formed in Step S1 is removed.

In Step S6, a first layer formation step is performed. Specifically, the first layer 12 is formed using silicon oxide by a thermal oxidation method on the entire surface of the silicon wafer etched in Step S5.

In Step S7, a second layer formation step is performed. Specifically, the second layer 14 is formed using silicon by a low-pressure CVD method on the entire surface of the first layer 12 formed in Step S6.

In Step S8, a third layer formation step is performed. Specifically, the third layer 16 is formed by the ALD method on the entire surface of the second layer 14 formed in Step S7. In such an instance, the third layer 16 is formed using a material having a refractive index different from that of the second layer 14, for example, any one of aluminum oxide, aluminum nitride, silicon nitride, titanium oxide, and hafnium oxide by using the ALD method.

In Step S9, a tie bar cut step is performed. Specifically, the base material 8 of the escape wheel and pinion portion 100 is cut from the tie bar supporting the base material 8.

Finally, in Step S10, an assembly step is performed. Specifically, the escape wheel and pinion 101 is assembled by combining the base material 8 of the escape wheel and pinion portion 100 cut from the tie bar in Step S9 and the shaft member 102.

Accordingly, in the present embodiment, since the ALD method is used for forming the third layer 16, the third layer 16 can be formed using materials having various refractive indices. Therefore, a realizable hue can be increased.

In this regard, since a reflecting layer stacking step of stacking the light-reflecting layer 10 on the entire surface of the base material 8 is performed before the tie bar cut step of cutting the tie bar supporting the base material 8, the light-reflecting layer 10 can be stacked on the entire surface of the base material 8. Further, since the light-reflecting layer 10 is also stacked on the surface of the tie bar, when the tie bar is cut, a change in the hue of the cut place can be made inconspicuous.

Further, in the present embodiment, since the first layer 12 is formed by the thermal oxidation method, and the second layer 14 is formed by the low-pressure CVD method, that is, since the first layer 12 and the second layer 14 are formed by methods other than the ALD method, the time for producing the escape wheel and pinion portion 100 can be decreased.

Example 1

Next, Examples according to the present disclosure will be described.

In Example 1, light-reflecting layers were formed on the surface of the respective base materials under five conditions presented in Table 1.

As presented in Table 1, the third layer was formed of silicon nitride by the ALD method in Examples 1-1, 1-4, and 1-5, the third layer was formed of aluminum oxide by the ALD method in Example 1-2, and the third layer was formed of aluminum nitride by the ALD method in Example 1-3. Consequently, the refractive index of the third layer was 1.7 to 2.0. In Examples 1-1 to 1-5, the first layer was formed of silicon oxide by the thermal oxidation method, and the second layer was formed of silicon by the low-pressure CVD method. In this regard, in Table 1, the layer thickness of the first layer includes a production error of $\pm 5$ nm, the layer thickness of the second layer includes a production error of $\pm 3$ nm, and the layer thickness of the third layer includes a production error of ±5 nm.

As a result, Examples 1-1 to 1-5 indicated that adjustment was able to be performed, and thereby the hue was red, the brightness L* was within the range of 45.0 ± 10.0, a* was within the range of 60.0 ± 10.0, and b* was within the range of 40.0 ± 10.0. That is, it was indicated that the third layer being formed by the ALD method enables a quiet, deep watch part having a hue of red and brightness L* of 45.0 ± 10.0 to be obtained.

In this regard, the brightness L* is a value of brightness in the L*a*b* color space specified by CIE (Commission Internationale d'Eclairage). The value of L* of "0" is the brightness of a substance that does not reflect light at all (completely absorb light), and the value of L* of "100" expresses the value of brightness of white that completely reflects light. In addition, the chroma C* is an indicator of the vividness of a color and is represented by a distance between a point expressed by a* and b* and the origin corresponding to an achromatic color.

$$C* = \sqrt{(a*)^2 + (b*)^2}$$    Formula (6)

Table 1

|  |  | Example 1-1 | Example 1-2 | Example 1-3 | Example 1-4 | Example 1-5 |
|---|---|---|---|---|---|---|
| First layer | Material | silicon oxide | silicon oxide | silicon oxide | silicon oxide | silicon oxide |
|  | Layer thickness | 170 nm | 162 nm | 350 nm | 170 nm | 355 nm |
|  | Refractive index | 1.5 | 1.5 | 1.5 | 1.5 | 1.5 |
| Second layer | Material | silicon | silicon | silicon | silicon | silicon |
|  | Layer thickness | 107 nm | 108 nm | 105 mm | 175 nm | 107 nm |
|  | Refractive index | 4.1 | 4.1 | 4.1 | 4.1 | 4.1 |
| Third layer | Material | silicon nitride | aluminum oxide | aluminum nitride | silicon nitride | silicon nitride |
|  | Layer thickness | 55 mm | 66 nm | 55 mm | 55 nm | 55 nm |
|  | Refractive index | 1.8 | 1.7 | 2.0 | 1.8 | 1.8 |
| L* |  | 42.1 | 52.8 | 37.6 | 43.7 | 50.8 |
| a* |  | 55.4 | 52.1 | 57.2 | 51.7 | 60.4 |
| b* |  | 41.1 | 33.1 | 34.9 | 44.3 | 32.4 |
| Hue |  | red | red | red | red | red |

Example 2

In Example 2, light-reflecting layers were formed on the surface of the respective base materials under four conditions presented in Table 2.

As presented in Table 2, the third layer was formed of aluminum oxide by the ALD method in Examples 2-1 and 2-4, the third layer was formed of silicon nitride by the ALD method in Example 2-2, and the third layer was formed of titanium oxide in Example 2-3. Consequently, the refractive index of the third layer was 1.7 to 2.7. In Examples 2-1 to 2-4, the first layer was formed of silicon oxide by the thermal oxidation method, and the second layer was formed of silicon by the low-pressure CVD method. In this regard, in Table 2, the layer thickness of the first layer includes a production error of ±5 nm, the layer thickness of the second layer includes a production error of ±3 nm, and the layer thickness of the third layer includes a production error of ±5 nm.

As a result, Examples 2-1 to 2-4 indicated that adjustment was able to be performed, and thereby the hue was green, the brightness L* was within the range of 65.0 ± 10.0, a* was within the range of -65.0 ± 10.0, and b* was within the range of 50.0 ± 10.0. That is, it was indicated that the third layer being formed by the ALD method enables a quiet, deep watch part having a hue of green and brightness L* of 65.0 ± 10.0 to be obtained.

Table 2

| | | | Example 2-1 | Example 2-2 | Example 2-3 | Example 2-4 |
|---|---|---|---|---|---|---|
| First layer | | Material | silicon oxide | silicon oxide | silicon oxide | silicon oxide |
| | | Layer thickness | 450 mm | 450 nm | 430 nm | 255 nm |
| | | Refractive index | 1.5 | 1.5 | 1.5 | 1.5 |
| Second layer | | Material | silicon | silicon | silicon | silicon |
| | | Layer thickness | 85 nm | 80 nm | 79 nm | 85 nm |
| | | Refractive index | 4.1 | 4.1 | 4.1 | 4.1 |
| Third layer | | Material | aluminum oxide | silicon nitride | titanium oxide | aluminum oxide |
| | | Layer thickness | 51 nm | 55 mm | 36 mm | 51 nm |
| | | Refractive index | 1.7 | 1.8 | 2.5 - 2.7 | 1.7 |
| L* | | | 72.3 | 66.3 | 68.6 | 73.4 |
| a* | | | -63.9 | -58.9 | -60.9 | -59.7 |
| b* | | | 51.1 | 55.0 | 52.3 | 44.8 |
| Hue | | | green | green | green | green |

Example 3

In Example 3, light-reflecting layers were formed on the surface of the respective base materials under three conditions presented in Table 3.

As presented in Table 3, the third layer was formed of aluminum oxide by the ALD method in Examples 3-1 and 3-3, and the third layer was formed of aluminum nitride by the ALD method in Example 3-2. Consequently, the refractive index of the third layer was 1.7 to 2.0. In Examples 3-1 to 3-3, the first layer was formed of silicon oxide by the thermal oxidation method, and the second layer was formed of silicon by the low-pressure CVD method. In this regard, in Table 3, the layer thickness of the first layer includes a production error of $\pm 5$ nm, the layer thickness of the second layer includes a production error of $\pm 3$ nm, and the layer thickness of the third layer includes a production error of $\pm 5$ nm.

As a result, Examples 3-1 to 3-3 indicated that adjustment was able to be performed, and thereby the hue was yellow, the brightness L* was within the range of $80.0 \pm 10.0$, a* was within the range of $-5.0 \pm 10.0$, and b* was within the range of $83.0 \pm 10.0$. That is, it was indicated that the third layer being formed by the ALD method enables a quiet, deep watch part having a hue of yellow and brightness L* of $80.0 \pm 10.0$ to be obtained.

Accordingly, in the present disclosure, the third layer being formed of a material having a refractive index of 1.7 to 2.7 enables the brightness L* when the hue is red to be adjusted to $45.0 \pm 10.0$, enables the brightness L* when the hue is green to be adjusted to $65.0 \pm 10.0$, and enables the brightness L* when the hue is yellow to be adjusted to $80.0 \pm 10.0$. Consequently, a quiet, deep color with a predetermined hue can be realized.

Table 3

| | | | Example 3-1 | Example 3-2 | Example 3-3 |
|---|---|---|---|---|---|
| First layer | | Material | silicon oxide | silicon oxide | silicon oxide |
| | | Layer thickness | 295 nm | 295 nm | 295 nm |
| | | Refractive index | 1.5 | 1.5 | 1.5 |
| Second layer | | Material | silicon | silicon | silicon |
| | | Layer thickness | 38 nm | 83 nm | 95 nm |
| | | Refractive index | 4.1 | 4.1 | 4.1 |
| Third layer | | Material | aluminum oxide | aluminum nitride | aluminum oxide |
| | | Layer thickness | 60 nm | 54 mm | 60 nm |
| | | Refractive index | 1.7 | 2.0 | 1.7 |
| L* | | | 82.4 | 74.2 | 77.8 |

(continued)

|  | Example 3-1 | Example 3-2 | Example 3-3 |
|---|---|---|---|
| a* | -3.2 | -12.1 | -3.6 |
| b* | 84.5 | 80.3 | 75.9 |
| Hue | yellow | yellow | yellow |

Modified example

In this regard, the present disclosure is not limited to the above-described embodiment, and modifications within the scope of the claims are included in the present disclosure.

In the above-described embodiment, the watch part according to the present disclosure is configured to serve as the escape wheel and pinion portion 100, but the watch part is not limited to this. For example, the watch part according to the present disclosure may be configured to serve as a part housed in a case, such as a movement barrel complete, an ordinal number wheel and pinion, an escape wheel and pinion, a pallet folk, a balance with hairspring, and a mainspring.

The escape wheel and pinion portion 100 according to the above-described embodiment may include an antifouling layer or an antistatic layer having transparency as an outermost layer within the bounds of not impairing the decorativeness. Accordingly, the escape wheel and pinion portion 100 is provided with an antifouling function or an antistatic function.

In addition, as the situation demands, a step for any purpose can be added to the producing method of the escape wheel and pinion portion 100 according to the above-described embodiment. For example, an intermediate treatment, such as washing, may be performed between the steps.

Outline of the present disclosure

A watch part according to the present disclosure includes a base material having a watch part shape and containing silicon as a primary component and a light-reflecting layer stacked on the base material, wherein the light-reflecting layer includes a first layer, a second layer, and a third layer which are successively stacked in this order from the base material, the first layer is formed using silicon oxide, the second layer is formed using silicon, and the third layer is formed using a material having a refractive index of 1.7 to 2.7.

In the present disclosure, since the third layer is formed using a material having a refractive index of 1.7 to 2.7, a difference in the refractive index between the second layer formed using silicon and the third layer can be decreased. Consequently, color development is suppressed and a quiet, deep watch part can be realized.

In this regard, when the third layer is stacked by the thermal oxidation method on the second layer formed using silicon, variations in the layer thicknesses of the silicon layer serving as the second layer 14 and the third layer 16 occur from production to production due to the crystallinity, density, and the like of the silicon layer serving as the second layer 14. Consequently, there is a problem that it is difficult to perform adjustment to obtain a predetermined hue. On the other hand, in the present disclosure, the layer thickness of the second layer 14 is not changed since the third layer is formed by using the ALD method. Therefore, adjustment to obtain a predetermined hue can be readily performed.

Further, since the first layer formed using silicon oxide is stacked on the base material, the durability of the base material can be enhanced.

In the watch part according to the present disclosure, L* = 45.0 ± 10, a* = 60.0 ± 10, and b* = 40.0 ± 10 may apply in the L*a*b* color space specified by CIE.

Accordingly, a quiet, deep watch part having a hue of red and brightness L* of 45.0 ± 10.0 can be obtained.

In the watch part according to the present disclosure, the third layer may be formed using any one of aluminum oxide, aluminum nitride, silicon nitride, titanium oxide, and hafnium oxide.

Accordingly, the refractive index of the third layer at a wavelength of 632.8 nm can be set to be 1.7 to 2.7.

In the watch part according to the present disclosure, the third layer may be formed using aluminum oxide, a layer thickness of the first layer may be 162 ± 5 nm, a layer thickness of the second layer may be 108 ± 3 nm, and a layer thickness of the third layer may be 66 ± 5 nm.

Accordingly, a quiet, deep watch part having a hue of red and brightness L* of 45.0 ± 10.0 can be obtained.

In the watch part according to the present disclosure, the third layer may be formed using silicon nitride, a layer thickness of the first layer may be 170 ± 5 nm, a layer thickness of the second layer may be 107 ± 3 nm, and a layer thickness of the third layer may be 55 ± 5 nm.

Accordingly, a quiet, deep watch part having a hue of red and brightness L* of 45.0 ± 10.0 can be obtained.

In the watch part according to the present disclosure, the third layer may be formed using aluminum nitride, a layer thickness of the first layer may be 350 ± 5 nm, a layer thickness of the second layer may be 105 ± 3 nm, and a layer thickness of the third layer may be 55 ± 5 nm.

Accordingly, a quiet, deep watch part having a hue of red and brightness L* of 45.0 ± 10.0 can be obtained.

In the watch part according to the present disclosure, L* = 65.0 ± 10, a* = -65.0 ± 10, and b* = 50.0 ± 10 may apply in the L*a*b* color space specified by CIE.

Accordingly, a quiet, deep watch part having a hue of green and brightness L* of 65.0 ± 10.0 can be obtained.

In the watch part according to the present disclosure, the third layer may be formed using aluminum oxide, a layer thickness of the first layer may be 450 ± 5 nm, a layer thickness of the second layer may be 85 ± 3 nm, and a layer thickness of the third layer may be 51 ± 5 nm.

Accordingly, a quiet, deep watch part having a hue of green and brightness L* of 65.0 ± 10.0 can be obtained.

In the watch part according to the present disclosure, the third layer may be formed using silicon nitride, a layer thickness of the first layer may be 450 ± 5 nm, a layer thickness of the second layer may be 80 ± 3 nm, and a layer thickness of the third layer may be 55 ± 5 nm.

Accordingly, a quiet, deep watch part having a hue of green and brightness L* of 65.0 ± 10.0 can be obtained.

In the watch part according to the present disclosure, the third layer may be formed using titanium oxide, a layer thickness of the first layer may be 430 ± 5 nm, a layer thickness of the second layer may be 79 ± 3 nm, and a layer thickness of the third layer may be 36 ± 5 nm.

Accordingly, a quiet, deep watch part having a hue of green and brightness L* of 65.0 ± 10.0 can be obtained.

In the watch part according to the present disclosure, L* = 80.0 ± 10, a* = -5.0 ± 10, and b* = 83.0 ± 10 may apply in the L*a*b* color space specified by CIE.

Accordingly, a quiet, deep watch part having a hue of yellow and brightness L* of 80.0 ± 10.0 can be obtained.

In the watch part according to the present disclosure, the third layer may be formed using aluminum oxide, a layer thickness of the first layer may be 295 ± 5 nm, a layer thickness of the second layer may be 38 ± 3 nm, and a layer thickness of the third layer may be 60 ± 5 nm.

Accordingly, a quiet, deep watch part having a hue of yellow and brightness L* of 80.0 ± 10.0 can be obtained.

In the watch part according to the present disclosure, the third layer may be formed using aluminum nitride, a layer thickness of the first layer may be 295 ± 5 nm, a layer thickness of the second layer may be 83 ± 3 nm, and a layer thickness of the third layer may be 54 ± 5 nm.

Accordingly, a quiet, deep watch part having a hue of yellow and brightness L* of 80.0 ± 10.0 can be obtained.

A watch according to the present disclosure includes the above-described watch part.

## Claims

1. A watch part (100) comprising:

   a base material (8) having a watch part shape and containing silicon as a primary component; and
   a light-reflecting layer (10) stacked on the base material (8), wherein
   the light-reflecting layer (10) includes a first layer (12), a second layer (14), and a third layer (16) which are successively stacked in this order from the base material (8),
   the first layer (12) is formed using silicon oxide,
   the second layer (14) is formed using silicon, and
   **characterised in that**:
   the third layer (16) is formed using a material having a refractive index of 1.7 to 2.7.

2. The watch part according to claim 1, wherein the resulting brightness of the light-reflecting layer is defined by L* = 45.0 ± 10, a* = 60.0 ± 10, and b* = 40.0 ± 10 apply in the L*a*b* color space specified by CIE.

3. The watch part according to claim 1, wherein
   the third layer is formed using any one of aluminum oxide, aluminum nitride, silicon nitride, titanium oxide, and hafnium oxide.

4. The watch part according to claim 1, wherein

   the third layer is formed using aluminum oxide,
   a layer thickness of the first layer is 162 ± 5 nm,
   a layer thickness of the second layer is 108 ± 3 nm, and
   a layer thickness of the third layer is 66 ± 5 nm.

5. The watch part according to claim 1, wherein

the third layer is formed using silicon nitride,
a layer thickness of the first layer is 170 ± 5 nm,
a layer thickness of the second layer is 107 ± 3 nm, and
a layer thickness of the third layer is 55 ± 5 nm.

6. The watch part according to claim 1, wherein

the third layer is formed using aluminum nitride,
a layer thickness of the first layer is 350 ± 5 nm,
a layer thickness of the second layer is 105 ± 3 nm, and
a layer thickness of the third layer is 55 ± 5 nm.

7. The watch part according to claim 1, wherein the resulting brightness of the light-reflecting layer is defined by $L^* = 65.0 \pm 10$, $a^* = -65.0 \pm 10$, and $b^* = 50.0 \pm 10$ apply in the L*a*b* color space specified by CIE.

8. The watch part according to claim 1, wherein

the third layer is formed using aluminum oxide,
a layer thickness of the first layer is 450 ± 5 nm,
a layer thickness of the second layer is 85 ± 3 nm, and
a layer thickness of the third layer is 51 ± 5 nm.

9. The watch part according to claim 1, wherein

the third layer is formed using silicon nitride,
a layer thickness of the first layer is 450 ± 5 nm,
a layer thickness of the second layer is 80 ± 3 nm, and
a layer thickness of the third layer is 55 ± 5 nm.

10. The watch part according to claim 1, wherein

the third layer is formed using titanium oxide,
a layer thickness of the first layer is 430 ± 5 nm,
a layer thickness of the second layer is 79 ± 3 nm, and
a layer thickness of the third layer is 36 ± 5 nm.

11. The watch part according to claim 1, wherein the resulting brightness of the light-reflecting layer is defined by $L^* = 80.0 \pm 10$, $a^* = -5.0 \pm 10$, and $b^* = 83.0 \pm 10$ apply in the L*a*b* color space specified by CIE.

12. The watch part according to claim 1, wherein

the third layer is formed using aluminum oxide,
a layer thickness of the first layer is 295 ± 5 nm,
a layer thickness of the second layer is 38 ± 3 nm, and
a layer thickness of the third layer is 60 ± 5 nm.

13. The watch part according to claim 1, wherein

the third layer is formed using aluminum nitride,
a layer thickness of the first layer is 295 ± 5 nm,
a layer thickness of the second layer is 83 ± 3 nm, and
a layer thickness of the third layer is 54 ± 5 nm.

14. The watch part according to claim 1, wherein
the third layer is formed by using an ALD method.

**15.** A watch comprising the watch part according to claim 1.

**Patentansprüche**

**1.** Uhrenteil (100), umfassend:

ein Basismaterial (8), das eine Uhrenteilform aufweist und Silizium als eine Primärkomponente enthält; und
eine lichtreflektierende Schicht (10), die auf das Basismaterial (8) gestapelt ist, wobei
die lichtreflektierende Schicht (10) eine erste Schicht (12), eine zweite Schicht (14) und eine dritte Schicht (16)
beinhaltet, die der Reihe nach in dieser Reihenfolge von dem Basismaterial (8) aus gestapelt sind,
die erste Schicht (12) unter Verwendung von Siliziumoxid gebildet wird,
die zweite Schicht (14) unter Verwendung von Silizium gebildet wird und
**dadurch gekennzeichnet, dass**:
die dritte Schicht (16) unter Verwendung eines Materials mit einem Brechungsindex von 1,7 bis 2,7 gebildet wird.

**2.** Uhrenteil nach Anspruch 1, wobei die resultierende Helligkeit der lichtreflektierenden Schicht durch
$L^* = 45,0 \pm 10$, $a^* = 60,0 \pm 10$ und $b^* = 40,0 \pm 10$ im L*a*b*-Farbraum definiert ist, der von CIE spezifiziert ist.

**3.** Uhrenteil nach Anspruch 1, wobei
die dritte Schicht unter Verwendung eines von Aluminiumoxid, Aluminiumnitrid, Siliziumnitrid, Titanoxid und Hafniumoxid gebildet wird.

**4.** Uhrenteil nach Anspruch 1, wobei

die dritte Schicht unter Verwendung von Aluminiumoxid gebildet wird,
eine Schichtdicke der ersten Schicht $162 \pm 5$ nm ist,
eine Schichtdicke der zweiten Schicht $108 \pm 3$ nm ist und
eine Schichtdicke der dritten Schicht $66 \pm 5$ nm ist.

**5.** Uhrenteil nach Anspruch 1, wobei

die dritte Schicht unter Verwendung von Siliziumnitrid gebildet wird,
eine Schichtdicke der ersten Schicht $170 \pm 5$ nm ist,
eine Schichtdicke der zweiten Schicht $107 \pm 3$ nm ist und
eine Schichtdicke der dritten Schicht $55 \pm 5$ nm ist.

**6.** Uhrenteil nach Anspruch 1, wobei

die dritte Schicht unter Verwendung von Aluminiumnitrid gebildet wird,
eine Schichtdicke der ersten Schicht $350 \pm 5$ nm ist,
eine Schichtdicke der zweiten Schicht $105 \pm 3$ nm ist und
eine Schichtdicke der dritten Schicht $55 \pm 5$ nm ist.

**7.** Uhrenteil nach Anspruch 1, wobei die resultierende Helligkeit der lichtreflektierenden Schicht durch
$L^* = 65,0 \pm 10$, $a^* = -65,0 \pm 10$, und $b^* = 50,0 \pm 10$ im L*a*b*-Farbraum definiert ist, der von CIE spezifiziert ist.

**8.** Uhrenteil nach Anspruch 1, wobei

die dritte Schicht unter Verwendung von Aluminiumoxid gebildet wird,
eine Schichtdicke der ersten Schicht $450 \pm 5$ nm ist,
eine Schichtdicke der zweiten Schicht $85 \pm 3$ nm ist und
eine Schichtdicke der dritten Schicht $51 \pm 5$ nm ist.

**9.** Uhrenteil nach Anspruch 1, wobei

die dritte Schicht unter Verwendung von Siliziumnitrid gebildet wird,
eine Schichtdicke der ersten Schicht $450 \pm 5$ nm ist,

eine Schichtdicke der zweiten Schicht 80 ± 3 nm ist und
eine Schichtdicke der dritten Schicht 55 ± 5 nm ist.

10. Uhrenteil nach Anspruch 1, wobei

dritte Schicht unter Verwendung von Titanoxid gebildet wird,
eine Schichtdicke der ersten Schicht 430 ± 5 nm ist,
eine Schichtdicke der zweiten Schicht 79 ± 3 nm ist und
eine Schichtdicke der dritten Schicht 36 ± 5 nm ist.

11. Uhrenteil nach Anspruch 1, wobei die resultierende Helligkeit der lichtreflektierenden Schicht durch
L* = 80,0 ± 10, a* = -5,0 ± 10, und b* = 83,0 ± 10 im L*a*b*-Farbraum definiert ist, der von CIE spezifiziert ist.

12. Uhrenteil nach Anspruch 1, wobei

die dritte Schicht unter Verwendung von Aluminiumoxid gebildet wird,
eine Schichtdicke der ersten Schicht 295 ± 5 nm ist,
eine Schichtdicke der zweiten Schicht 38 ± 3 nm ist und
eine Schichtdicke der dritten Schicht 60 ± 5 nm ist.

13. Uhrenteil nach Anspruch 1, wobei

die dritte Schicht unter Verwendung von Aluminiumnitrid gebildet wird,
eine Schichtdicke der ersten Schicht 295 ± 5 nm ist,
eine Schichtdicke der zweiten Schicht 83 ± 3 nm ist und
eine Schichtdicke der dritten Schicht 54 ± 5 nm ist.

14. Uhrenteil nach Anspruch 1, wobei
die dritte Schicht unter Verwendung eines ALD-Verfahrens gebildet wird.

15. Uhr, umfassend das Uhrenteil nach Anspruch 1.

**Revendications**

1. Pièce de montre (100) comprenant :

un matériau de base (8) présentant une forme de pièce de montre et contenant du silicium comme composant primaire ; et
une couche réfléchissant la lumière (10) empilée sur le matériau de base (8), dans laquelle
la couche réfléchissant la lumière (10) inclut une première couche (12), une deuxième couche (14) et une troisième couche (16), lesquelles sont empilées successivement dans cet ordre à partir du matériau de base (8),
la première couche (12) est formée au moyen d'oxyde de silicium,
la deuxième couche (14) est formée au moyen de silicium, et
**caractérisée en ce que** :
la troisième couche (16) est formée au moyen d'un matériau présentant un indice de réfraction compris entre 1,7 et 2,7.

2. Pièce de montre selon la revendication 1, dans laquelle la luminosité résultante de la couche réfléchissant la lumière est définie par
L* = 45,0 ± 10, a* = 60,0 ± 10, et b* = 40,0 ± 10 s'appliquent dans l'espace chromatique L*a*b* spécifié par CIE.

3. Pièce de montre selon la revendication 1, dans laquelle
la troisième couche est formée au moyen de l'un quelconque parmi l'oxyde d'aluminium, le nitrure d'aluminium, le nitrure de silicium, l'oxyde de titane et l'oxyde d'hafnium.

4. Pièce de montre selon la revendication 1, dans laquelle

la troisième couche est formée au moyen d'oxyde d'aluminium,
une épaisseur de couche de la première couche est de 162 ± 5 nm,
une épaisseur de couche de la deuxième couche est de 108 ± 3 nm, et
une épaisseur de couche de la troisième couche est de 66 ± 5 nm.

5. Pièce de montre selon la revendication 1, dans laquelle

la troisième couche est formée au moyen de nitrure de silicium,
une épaisseur de couche de la première couche est de 170 ± 5 nm,
une épaisseur de couche de la deuxième couche est de 107 ± 3 nm, et
une épaisseur de couche de la troisième couche est de 55 ± 5 nm.

6. Pièce de montre selon la revendication 1, dans laquelle

la troisième couche est formée au moyen de nitrure d'aluminium,
une épaisseur de couche de la première couche est de 350 ± 5 nm,
une épaisseur de couche de la deuxième couche est de 105 ± 3 nm, et
une épaisseur de couche de la troisième couche est de 55 ± 5 nm.

7. Pièce de montre selon la revendication 1, dans laquelle la luminosité résultante de la couche réfléchissant la lumière est définie par
L* = 65,0 ± 10, a* = -65,0 ± 10, et b* = 50,0 ± 10 s'appliquent dans l'espace chromatique L*a*b* spécifié par CIE.

8. Pièce de montre selon la revendication 1, dans laquelle

la troisième couche est formée au moyen d'oxyde d'aluminium,
une épaisseur de couche de la première couche est de 450 ± 5 nm,
une épaisseur de couche de la deuxième couche est de 85 ± 3 nm, et
une épaisseur de couche de la troisième couche est de 51 ± 5 nm.

9. Pièce de montre selon la revendication 1, dans laquelle

la troisième couche est formée au moyen de nitrure d'aluminium,
une épaisseur de couche de la première couche est de 450 ± 5 nm,
une épaisseur de couche de la deuxième couche est de 80 ± 3 nm, et
une épaisseur de couche de la troisième couche est de 55 ± 5 nm.

10. Pièce de montre selon la revendication 1, dans laquelle

la troisième couche est formée au moyen d'oxyde de titane,
une épaisseur de couche de la première couche est de 430 ± 5 nm,
une épaisseur de couche de la deuxième couche est de 79 ± 3 nm, et
une épaisseur de couche de la troisième couche est de 36 ± 5 nm.

11. Pièce de montre selon la revendication 1, dans laquelle la luminosité résultante de la couche réfléchissant la lumière est définie par
L* = 80,0 ± 10, a* = -5,0 ± 10, et b* = 83,0 ± 10 s'appliquent dans l'espace chromatique L*a*b* spécifié par CIE.

12. Pièce de montre selon la revendication 1, dans laquelle

la troisième couche est formée au moyen d'oxyde d'aluminium,
une épaisseur de couche de la première couche est de 295 ± 5 nm,
une épaisseur de couche de la deuxième couche est de 38 ± 3 nm, et
une épaisseur de couche de la troisième couche est de 60 ± 5 nm.

13. Pièce de montre selon la revendication 1, dans laquelle

la troisième couche est formée au moyen de nitrure d'aluminium,

une épaisseur de couche de la première couche est de 295 ± 5 nm,
une épaisseur de couche de la deuxième couche est de 83 ± 3 nm, et
une épaisseur de couche de la troisième couche est de 54 ± 5 nm.

14. Pièce de montre selon la revendication 1, dans laquelle
la troisième couche est formée au moyen d'un procédé ALD.

15. Montre comprenant la pièce de montre selon la revendication 1.

# FIG. 1

# FIG. 2

# FIG. 3

# FIG. 4

# FIG. 5

## FIG. 6

```
                    START

OXIDE FILM FORMATION STEP        ~S1

PHOTORESIST APPLICATION STEP     ~S2

EXPOSURE-DEVELOPMENT STEP        ~S3

ETCHING STEP                     ~S4

OXIDE FILM REMOVAL STEP          ~S5

FIRST LAYER FORMATION STEP       ~S6

SECOND LAYER FORMATION STEP      ~S7

THIRD LAYER FORMATION STEP       ~S8

TIE BAR CUT STEP                 ~S9

ASSEMBLY STEP                    ~S10

                    END
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024024390 A
- JP 2020148651 A

- US 2020292991 A1

**Non-patent literature cited in the description**

- **KAZUAKI SAKOTA**. Fotonikku Kesshou Nyuumon (introduction to Photonic Crystal). Morikita Publishing Co., 2004, 28-32, 41-43